# EUROPEAN PATENT APPLICATION

(11) **EP 3 468 310 A1**
(43) Date of publication of application: **10.04.2019**
(21) Application number: 17195319.3
(22) Date of filing: 06.10.2017
(51) Int. Cl.: H05K 1/02, H05K 1/05, H05K 3/46, B29C 64/153, H05K 3/12

(54) **COMPONENT CARRIER HAVING A THREE DIMENSIONALLY PRINTED COOLING STRUCTURE**

(71) Applicant: AT & S Austria Technologie & Systemtechnik Aktiengesellschaft, 8700 Leoben-Hinterberg (AT)
(72) Inventor: Silvano de Sousa, Jonathan, 1100 Wien (AT); Leitgeb, Markus, 8793 Trofaiach (AT); Lutschounig, Ferdinand, 9170 Ferlach (AT); Krivec, Thomas, 8740 Zeltweg (AT); Morianz, Mike, 8045 Graz (AT)
(74) Representative: Dilg, Haeusler, Schindelmann Patentanwaltsgesellschaft mbH

(57) **Abstract**

A component carrier and a method for manufacturing a component carrier is described wherein the component carrier comprises a carrier body which comprises a plurality of electrically conductive layer structures and/or electrically insulating layer structures and a cooling structure on and/or in the layer structures wherein the cooling structure being at least partially formed as a three-dimensionally printed structure.

## Description

### Field of invention

The invention relates to a component carrier having cooling structure. Further, the invention relates to a method of manufacturing a component carrier having a cooling structure.

### Art Background

Conventional component carriers comprise cooling structures which are formed as a separate part mounted on or arranged in the component carrier. The cooling structures are attached on the component carrier for increasing heat dissipation such that the heat is reduced and as effect keeping the operational temperature due to power losses produced by components arranged on the component carrier at controllable levels. The efficiency of the heat reduction and the resulting temperature reduction may vary depending on the accuracy of the attachment, for example a mechanical coupling, of the cooling structure to the component carrier. Further, due to high power requirements, the ever increasing component miniaturization and high components density on modern electronic applications, there is an escalating demand for efficient cooling management strategies. Even slight increases of the overall operational temperature will effect exponentially the live time of electronic components. This leads to cooling structures which have to be manufactured with more precision and to an enhanced attachment of these cooling structures to the components to be cooled. Therefore, with continuous demand for improved heat dissipation and heat reduction, there is still room for improved cooling structures and component carriers comprising such cooling structures.

### Summary of the Invention

It is an object of the invention to provide a component carrier having a cooling structure which provides more flexibility in the arrangement of the cooling structure and more accuracy in designing the cooling structure.

In order to achieve the object defined above a component carrier and a method of manufacturing a component carrier according to the independent claims are provided.

According to a first aspect of the invention, there is provided a component carrier, wherein the component carrier comprises a carrier body. The carrier body comprises a plurality of electrically conductive layer structures and/or electrically insulating layer structures. The component carrier further comprises a cooling structure on and/or in the layer structures and being at least partially formed as a three-dimensionally printed structure.

According to another aspect of the invention, a method for manufacturing a component carrier is provided. The method comprises providing a carrier body comprising a plurality of electrically conductive layer structures and/or electrically insulating layer structures and forming a cooling structure on and/or in the layer structures at least partially by three-dimensionally printing.

In the context of the present document, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above mentioned types of component carriers.

In an embodiment, the component carrier comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure, if desired supported by thermal energy. The mentioned stack may provide a plate-shaped component carrier capable of providing a large mounting surface for further components and being nevertheless very thin and compact. The term "layer structure" may particularly denote a continuous layer, a patterned layer or a plurality of non-consecutive islands within a common plane. The component carrier comprises the carrier body which is comprised of different layer structures, i.e. the electrical insulating and electrical conductive layer structures. The different layer structures may be arranged, such that the order of the electrical insulating layer structure and the electrical conductive layer structure are alternating. For example the carrier body may have layer structure starting with the electrical conductive layer structure followed by an electrical insulating layer structure further followed by an electrical conductive layer structure such that the stack of the component carrier is formed.

In the context of the present document, the term "cooling structure" may particularly denote a structure used for cooling down an area or an element to which the cooling structure may be applied. The cooling structure may be used to thermally connect two different parts, for example two different parts from one component carrier, such as two different layer structures and/or conductive lines. The cooling structure may dissipate the excessive heat to the surrounding parts of the component carrier and/or to the surrounding ambient air. The excessive heat may also be transferred away from the cooling structure by use of a gas or fluid stream as a cooling medium. The cooling structure absorbs the generated heat and dissipates the generated heat to the surrounding area. The cooling structure may be an active and/or a passive cooling structure. A passive cooling structure uses convection for transferring the excessive heat to the surrounding, e.g. air. An active cooling structure may comprise cooling tubes through which a cooling medium flows. An active cooling structure may comprise pumps or ventilators for pumping the cooling medium through the cooling tubes and/or for pumping away from the cooling structure. Furthermore, the cooling structure may simultaneously transfer heat away from a heated component and it may be used for transferring electrical signals via electrical connections. The cooling structure may be electrically conductive or electrically isolating.

In the context of the present document, the term "three dimensionally printed structure" may particularly denote a structure formed by a three dimensionally printing process. The three dimensional structures are designed under computer control to create a 3D structure. By using the three dimensional printing procedure, the 3D printed structure may be formed layer by layer. In particular, three dimensionally printing denotes for example 3D printing using powder materials, 3D printing using meltable materials, 3D printing using fluid materials. Another process using a printing material in powder form is selective laser sintering (SLS) or selective laser melting (SLM). A further process using printing material in powder form is electron beam melting (EBM, or also called electron beam additive manufacturing EBAM). 3D printing by meltable materials may particularly denote fused filament fabrication (FFF) or fused deposition modeling (FDM). Melted materials which will be used for this process may be in particular plastics like ABS or PLA. 3D printing by fluid materials may particularly denote the manufacturing process which is working on the basis of fluidic UV-sensitive plastics (photopolymer, also other materials which are sensitive to other wavelength may be used). In particular, the 3-D printing with fluid materials may denote the so-called stereolithography (SLA). During this process the 3-D structure is also formed layer by layer.
Forming the cooling structure using a three dimensionally printing process may ease the manufacturing of the cooling structure. Further, the design of the cooling structure may be adapted to the element which has to be cooled accordingly, such that a proper heat transfer may be achieved. Using three dimensionally printing may guarantee more accuracy during the forming of the cooling structure and the arrangement of the cooling structure on the respective component and/or component carrier. Hence, miniaturized cooling structures may be formed which may be adapted for miniaturized electronic components.

It is mentioned that the term "layer structures" is used in this document representative for the plurality of electrically conductive layer structures and the electrically insulating layer structures forming the carrier body.

In an embodiment, the component carrier may comprise a component mounted on and/or embedded in the carrier body. The component may be an electrical component or device for performing different functions depending on the application into which the component carrier is attached. The component may be mounted on and/ or embedded in at least one of the plurality of electrically insulating layer structures and/or mounted on and/or embedded in at least one of the plurality of electrically conductive layer structures.

In an embodiment, the cooling structure is directly formed on the component. Directly forming on the component may denote that the cooling structure is directly 3D printed on the component. The directly printing may particularly comprise that no adhesive or other layers are arranged between the cooling structure and the component such that the cooling structure is directly formed on a surface of the component. The cooling structure is formed directly on the component without material/layers in between. Therefore, a proper thermal conductivity and/or electrical conductivity between the cooling structure and the surface of the component can be provided.

In an embodiment, the cooling structure comprises a material selected of at least one of the group consisting of copper, aluminum, steel and ceramics. Due to the use of different materials different functions may be applied to the cooling structure such that different heat dissipation properties may be achieved. Different materials may be applied on/in at least one layer structure such that different materials are 3-D printed on one layer structure for forming the cooling structure. It may also be possible to apply different materials to different layer structures. For example, the electronically conductive layer structure is a copper layer structure and the cooling structure which will be printed on/in the copper layer structure is another metal material (e.g. gold, aluminum, steel, titanium). On the other side the layer structure may be formed of a material, different than copper, and the printed cooling structure may be a copper material.

In an embodiment, the cooling structure is formed at least partially within the carrier body. The cooling structure may be partially in contact with conductive lines or electrically components on or within the carrier body, which have to be cooled. By forming the cooling structure on or within the carrier body a direct contact between the components to be cooled and the cooling structure may be achieved such that proper heat dissipation path may be produced. Further, by arranging the cooling structure on or within the carrier body more than one component may be cooled by at least one cooling structure. The cooling structure may be formed as a metallic inlay, for example a copper inlay. A cooling structure arranged partially within the carrier body may be used for cooling components within the carrier body and components on the carrier body.

In an embodiment, the cooling structure is formed extending along a stacking direction of the plurality of layer structures. The layer structures of the component carrier may be arranged as a stack such that the different layer structures are arranged on top of each other, i.e. layer over layer. Therefore, the term "stacking direction" may particularly denote the direction along which the stapled layers are stapled with respect to each other. The stacking direction may be an extending direction through the plurality of layer structures.

In an embodiment, the cooling structure is formed such that the cooling structure extends perpendicular with respect to a stacking direction of the plurality of layer structures. The perpendicular extension with respect to the stacking direction may be an extending direction along at least one of the plurality of layer structures.

In an embodiment, the cooling structure may comprise different cross sections, in particular in a stacking direction of the plurality of layer structures and/or perpendicular with respect to a stacking direction of the plurality of layer structures. The cooling structure may comprise different cross sections in a direction of a plane extending in parallel with the plurality of layer structures and/or the cooling structure may comprise different cross sections in a direction of a plane extending perpendicular to the layer structures. Hence, the cooling structure may comprise different thicknesses in the plane parallel and/or perpendicular to the plurality of layer structures. With 3-D printing different thicknesses may be realized in a simple manner.

In an embodiment, the cooling structure comprises at least one locally roughened surface which has a higher roughness than adjacent surfaces of the cooling structure for providing more efficient heat exchange with a cooling medium. The roughened surface may extend in a direction perpendicular to a stacking direction of the layer structures, i.e. in a direction of a plane extending parallel to the layer structures. A roughened surface provides a higher frictional resistance (turbulent flow) for a gas or fluidic medium flowing along the roughened surface such that a better heat exchange may be provided by a high roughened surface instead of a smooth or non-roughened surface. A smooth surface may be a polished surface. Roughness may be determined with the average roughness Ra. The range of the roughness may be between 500 µm for a high roughness and 100nm for a smooth surface. A high roughness allows a larger surface contact area and consequently better heat dissipation. For example a cooling process using a fluid medium may be directly proportional to the contact surface to be cooled (e.g. the surface of the component). A rough surface, in particular a high roughened surface, may generate a turbulent flow of a cooling medium along the roughened surface. A turbulent flow may improve the heat exchange compared to a heat exchange with a laminar flow. For example, by selecting a three dimensionally printing material having a larger particle size, a rough surface of the carrier body (or of a component) may be formed. Another possible way to adjust the roughness is through the scanning parameters of the laser, i.e. pulse duration, scanning strategy (raster single pass or cross-linked, spiral, island-like), etc. For example specifically, by using selective laser sintering (SLS) a rough surface of the carrier body (or of a component) can be formed. The result of a locally roughened (rugged) surface is that the heat radiation capacity of the locally roughened surface is increased. Hence, by the locally roughened surface a higher heat transfer to the environment is provided in comparison to smoother and less rough surfaces of the carrier body or the locally non-roughed surface of the component (which may be adjacent to the locally roughened surface). The higher heat transfer of the roughed surface may result of the better infrared radiation of the roughed surface. Hence, by forming locally roughened surface regions of higher roughness a heat transfer can be adjusted applying a determined roughness to surfaces. Hence, the thermal management of the component carrier can be adjusted exactly. Application of the improved cooling structure having a roughened surface may be to high power devices, high performance computational units or automotive devices.

In an embodiment, the cooling structure comprises a heat pipe. The heat pipe may be a heat transfer device that combines the principles of both thermal conductivity and phase transition to efficiently manage the transfer of heat between two solid interfaces, for example the carrier body on the one side and the environment of the cooling structure on the other side. At the hot interface of the heat pipe at the carrier body a cooling fluid may be in contact with a thermally conductive solid surface (i.e. at the carrier body) turns into a vapor by absorbing heat from that surface. The vapor then travels along the heat pipe to the cold interface and condenses back into a liquid to thereby releasing the latent heat. The liquid then returns to the hot interface by either capillary action, centrifugal force or gravity, and the cycle repeats. Due to the very high heat transfer coefficients for boiling and condensation, heat pipes are highly effective thermal conductors.

In an embodiment, the heat pipe comprises a tube extending along the carrier body. The tube may at least partially extend perpendicular a stacking direction of the layer structurer, i.e. that the tube extends in a direction of a plane parallel to the layer structures. The tube may extend along the whole length of the carrier body. The tube of the heat pipe may be arranged on top of the carrier body for transferring the generated heat to the ambient of the carrier body.

In an embodiment, the heat pipe forms a tube which partially surrounds a heat generating component. The heat generating components may be for example an electrical component as described below. Furthermore, the component may be for example a conductive line or another electrical guiding element. Hence, the tube forming a heat pipe may be formed in such a way, that the tube surrounds partially or completely the heat generating components. For example, the tube may have a ring shape, wherein in the center of the ring the heat generating component is arranged. Furthermore, the tube may comprise a heat radiation section which is located spaced apart a certain distance from the component. The tube comprises an inner cavity through which a cooling fluid flows. Thereby, the tube forms a heat pipe, wherein the cooling fluid receives the thermal energy from the heat generating component and flows further to the heat radiation section of the tube, where the thermal energy is transferred from the cooling fluid to the environment in order to cool down the cooling fluid. Hence, the cooled cooling fluid flows back to the region partially surrounding the heat generating components for receiving again thermal energy from the heat generating component. Specifically, by three dimensionally printing, the design of the tube may be flexible, such that the run and extension, respectively, of the tube along the component carrier may be individually adjusted. For example, the tube may extend in a meander-like manner along the carrier body. For example, the tube may partially surround one or a plurality of heat generating components, such that the cooling fluid may pass more than one heat generating components for cooling purposes.

In an embodiment, the heat pipe forming a tube described above may be used for active cooling wherein the tube is connected on both ends to a circulatory system in which a cooling fluid is set to flow through the tube under the action of a pump.

In an embodiment, the cooling structure comprises a heat sink. For example, the heat sink is formed by three dimensionally printing directly on the component and/or directly on the carrier body. The heat sink is formed by the three dimensionally printing on the component/ carrier body itself so that any heat resistive layers affecting the heat dissipation from the component or the carrier body are avoided. Therefore, it may be possible to enhance the heat conductivity of current available heat sink mount technologies. A heat sink is a passive heat exchanger that cools a device by dissipating heat into the surrounding medium.

In an embodiment, the cooling structure is formed as a fractal structure. A fractal is a mathematical set that exhibits a repeating pattern displayed at every scale. The fractal may be a detailed pattern that repeats itself. If the replication is exactly the same at every scale the pattern may be a self-similar pattern. A maximum surface with minimum volume may be produced using fractal structures on a surface or as the surface itself. A maximum surface with a minimum volume may increase the dissipatable heat to the surrounding ambient.

In an embodiment, the cooling structure forms a lamella structure. The cooling structure may form a plurality of lamella structures or cooling fins in order to increase to heat radiation surface of the cooling structure. The lamella structure may be a part of the heat sink such that the surface of the heat sink is enlarged for providing a greater surface for increased heat dissipation.

In an embodiment, the cooling structure forms a torus structure. The torus comprises a hole in the middle in which for example a component may be arranged such that heat generated in the middle may be dissipated by the torus surrounding the component. The torus structure may be a circular shaped heat conductive material, for example a copper ring. On the other hand the torus structure may be a heat pipe or water cooling pipe shaped as a torus.

In an embodiment, the cooling structure is formed as an electrically insulated thermally conductive metal body. In particular, the cooling structure is formed as an insulating metallic substrate (IMS) or copper inlay. This IMS/copper inlay may be used as an inlay in the carrier body or an upper surface of the carrier body for transferring heat form light emitting diodes and power components. The material used for the IMS may be aluminum or copper. The IMS may comprise a core made from aluminum or copper and a further layer made of an electrically insulating material covering the core.

In an embodiment, the cooling structure is configured as an electrical connector and/or thermal connector. The cooling structure may be configured for connecting at least one component to the component carrier, in particular to the carrier body. If the cooling structure is configured as a thermal connector the cooling structures serves for dissipating heat away from a heated component coupled by the thermal connector. If the cooling structure is configured as an electrical connector it may be used for transferring electrical signals via the electrical connections and simultaneously for transferring heat generated during the electrical connection. The connectors may be directly printed on the carrier body or on the component. The connectors may be configured for attaching the component (on which they are printed) or the carrier body to a heat sink thermally connecting the component (or the carrier body) by the connectors to the heat sink. Furthermore, the carrier body comprising the connectors may be coupled to a further carrier body, wherein the further carrier body may be configured to perform heat management. Hence, the cooling structure may be used for high power applications using a connector for enhanced heat reduction.

In an embodiment, the cooling structure comprises pins and/or connecting holes. The pins and/or the connecting holes of the cooling structure may be connected to respective holes or pins of the carrier body and/or the component. In particular, if the cooling structure may be formed as a heat sink the heat sink may comprise connecting holes for being configured to be connected to the carrier body, wherein the carrier body comprises the equivalent pins for the connecting holes. On the other hand the cooling structure may comprise pins extending from the cooling structure, wherein the pins may be configured for being connected to respective holes in the carrier body.

In an embodiment, the cooling structure comprises a thermal conductor, in particular a thermal conductive ceramic body, arranged on the carrier body, wherein the thermal conductor, i.e. the ceramic body, comprises a cooling surface to which a heat generating element, such as a conductive line and/or an electronical component, is attachable. The ceramic body may be configured for a locally heat dissipation on the carrier body. The ceramic body is configured for dissipating heat away from the heat generating element arranged on the ceramic body. In particular the ceramic body may be a supra conductive ceramic body which may be applicable for high current applications.

In an embodiment, the component may be selected from a group consisting of an electronic component, an electrically non-conductive and/or electrically conductive inlay (such as a metal inlay, preferably comprising copper or aluminum), a heat transfer unit (for example a heat pipe), a light guiding element (for example an optical waveguide or a light conductor connection), an energy harvesting unit, an active electronic component, a passive electronic component, an electronic chip, a storage device (for instance a DRAM or another data memory), a filter, an integrated circuit, a signal processing component, a power management component, an optoelectronic interface element, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, an accumulator, a switch, a camera, an antenna, a magnetic element, a further component carrier and a logic chip, and an energy harvesting unit. Combinations thereof may also be possible. However, other components may be embedded in the component carrier. For example, a magnetic element can be used as a component. Such a magnetic element may be a permanent magnetic element (such as a ferromagnetic element, an antiferromagnetic element or a ferrimagnetic element, for instance a ferrite core) or may be a paramagnetic element. However, the component may also be a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the at least one electrically conductive layer structure may comprise at least one of the group consisting of copper, aluminum, nickel, silver, gold, palladium, and tungsten. Although copper is usually preferred, other materials or coated versions thereof are possible as well, in particular coated with supra-conductive material such as graphene.

In an embodiment, the at least one electrically insulating layer structure comprises at least one of the group consisting of resin, in particular reinforced or non-reinforced resin, for instance epoxy resin or Bismaleimide-Triazine resin, FR-4, FR-5, cyanate ester, polyphenylene derivate, glass (in particular glass fibers, multi-layer glass, glass-like materials), prepreg material, polyimide, polyamide, liquid crystal polymer (LCP), epoxy-based Build-Up Film, polytetrafluoroethylene (Teflon), a ceramic, and a metal oxide. Reinforcing materials such as webs, fibers or spheres, for example made of glass (multilayer glass) may be used as well. Although prepreg or FR4 are usually preferred, other materials may be used as well. For high frequency applications, high-frequency materials such as polytetrafluoroethylene, liquid crystal polymer and/or cyanate ester resins may be implemented in the component carrier as electrically insulating layer structure.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier is configured as one of the group consisting of a printed circuit board, and a substrate (in particular an IC substrate).

In the context of the present document, the term "printed circuit board" (PCB) may particularly denote a component carrier (which may be plate-shaped (i.e. planar), three-dimensionally curved (for instance when manufactured using 3D printing) or which may have any other shape) which is formed by laminating several electrically conductive layer structures with several electrically insulating layer structures, for instance by applying pressure, if desired accompanied by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming through-holes through the laminate, for instance by laser drilling or mechanical drilling, and by filling them with electrically conductive material (in particular copper), thereby forming vias as through-hole connections. These vias may be formed by three dimensionally printing. Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present document, the term "substrate" may particularly denote a small component carrier having substantially the same size as a component (in particular an electronic component) to be mounted thereon. More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing spheres (such as glass spheres).

In an embodiment the component carrier may be configured as a laminate-type component carrier. In such an embodiment, the component carrier is a compound of multiple layer structures which are stacked and connected together by applying a pressing force, if desired accompanied by heat.

In the following exemplary embodiments of the method will be described.

According to a further exemplary embodiment of the method, the three-dimensionally printing may comprise the steps of applying a printing material to an application device, melting the printing material in the application device, and applying the melted printing material on and/or in the carrier body (i.e. the layer structures) for forming at least one layer of the cooling structure (which is comprised of the melted (cooling structure) material). According to this embodiment for the manufacturing of the 3-D printed cooling structure meltable materials may be used. The material may be applied to a 3-D printer comprising a printhead functioning as the application device. The printhead may be a heatable extruder into which the material is supplied. Inside the extruder the material is melted, such that the material can be transferred through the extruder (e.g. an extruder nozzle) to a structure onto which the melted material is to be applied, e.g. at least one of the layer structures. The application device and the carrier body can be moved with respect to each other. After solidifying (curing/hardening) the applied layer of the cooling structure, subsequently a further layer of the cooling structure may be formed. The number of the formed layers of the cooling structure depends on the size, in particular the height, of the cooling structure. For example, a formed layer may have a thickness of 50 µm. The cooling structure may have a thickness of 200 µm. Hence, four layers may be formed on top of each other. For example, the application device may have a high resolution such that single layers of a thickness of approx. 1 µm to 16 µm may be formed. During the manufacturing process more than one application devices may be used for applying different materials or for simultaneously manufacturing more than one cooling structure. According to this embodiment, it may be possible to form simultaneously more than one cooling structures on a common layer structure. Further, two cooling structures may be formed on/in two different layer structures (which means one cooling structure may be formed on/in the electrically conductive layer structure and the other cooling structure may be formed on/in the electrically insulating layer structure) before the component carrier is formed, in particular before the laminating of the different layer structures. The used meltable material may be made of an electrically conductive material, e.g. copper, or it may be enriched with electrically conductive material components.

According to a further exemplary embodiment of the method, the three-dimensionally printing may comprise the following steps: applying a printing material, in particular a powder material on and/or in the carrier body, and consolidating the applied printing material for forming at least one layer of the cooling structure. The term "consolidating" may particularly denote any step or activity for bringing the printed material in a solid state, wherein the solid state is the state of at least one layer structure made of the printing material. For example consolidating may be at least one of the following: adhering, gluing, curing, tempering, solidifying, melting and hardening or hardening of the printing material. The forming of the at least one layer of the cooling structure may be performed by applying an adhesive to the at least one layer of the cooling structure. The adhesive adhere the single particles of the powder material together such that a respective layer is formed. The adhesive may be applied by a printhead to the powder layer. The adhesive (binder) may be a fluidic adhesive. During the 3-D printing with powder, the first (lowermost) layer is applied with the fluidic adhesive on the powder layer by the printhead. The 3-D printer prints the 3-D image of the first layer on the powder bed and adhere the material particles together. After that, a further and thin powder layer is applied on the first layer and the procedure is repeated with a second layer. Thus, a 3-D model of the cooling structure is created by adhering layer to layer in a powder bed. The 3-D structure is growing from the bottom. Therefore, the powder bed is lowered about the height of a powder layer. Powder and adhesive may be comprised of different materials. For example, plastic powder, a ceramic powder, glass powder or other metal pulverulent materials may be used. It may also be possible to use metal as a powder material, for example copper powder for 3D printing cooling structures. The 3-D printer may be equipped with at least one print head, but more print heads may also be used. The used adhesive may be a conductive adhesive, such that the layer structures are formed by conductive metal powder and conductive adhesive for being electrically conductive. The adhesive may be cured by the use of the thermal treatment device, such as a heat lamp or a laser.

According to a further exemplary embodiment of the method, the cooling structure may be formed by at least one of the group consisting of selective laser melting, selective laser sintering, and electron beam melting.

According to a further exemplary embodiment, before consolidating the printing material the printing material is melted by a thermal treatment device, in particular a laser device. Instead of using an adhesive, the single layers are melted by means of a thermal treatment device, such as a laser, which is called selective laser sintering (SLS) or selective laser melting (SLM). Hence, metals, ceramics and sand may be used for SLS or SLM. When the SLS or SLM method is used for manufacturing, the forming of the layer of the powder material is performed by means of a laser, wherein the laser melts or sinters the powder material for forming at least one layer of the cooling structure. When using SLM or SLM manufacturing methods an adhesive for attaching the powder material may be obsolete.

Further, the powder may be melted by the use of a controllable electron beam, which will be called electron beam melting (EBM). This manufacturing process may allow to use materials comprising a higher melting point e.g. for melting also titanium materials.

According to a further exemplary embodiment of the method, the printing material may be applied by means of a material delivery nozzle. The printing material, e.g. the powder, is provided to the material delivery nozzle, such that the applied printing material may be spread out of the material delivery nozzle. A precise printing material amount may be delivered by the material delivery nozzle, such that only the cooling structure to be printed has to be covered with printing material instead of the whole component carrier or the whole layer structure.

According to a further exemplary embodiment, the method may further comprise moving the material delivery nozzle for forming a further layer of the cooling structure. The term "moving" may particularly denote a movement along at least one spatial direction for adjusting the material delivery nozzle with respect to the carrier body. For example, a distance between the carrier body and the material delivery nozzle may be adjusted. Furthermore, the material delivery nozzle may be moved along further spatial direction in order to adjust a desired alignment between the carrier body and the material delivery nozzle. Depending on the movement of the material delivery nozzle, the thickness and location of the layer to be formed is adjusted. This step may be repeated until the final thickness of the cooling structure is received such that the cooling structure is formed by spreading printing material layer by layer.

According to a further exemplary embodiment, before the printing material is applied on and/or in the carrier body the carrier body is provided into a material bed consisting of the printing material. The carrier body may be placed into the material bed. The component carrier may be completely covered by the printing material arranged inside the material bed. The carrier body may be adjusted in the material bed such that a surface of the carrier body, onto which the cooling structure should be formed, is arranged with a defined distance to a surface of the material bed. Hence, between the environment and the surface of the carrier body, a desired thickness of printing material is arranged. Next, by a treatment device as described below, which may be a thermal treatment device for applying thermal energy to the surface of the material bed or for radiating a predefined wavelength of light for photopolymerization to the surface of the material bed, consolidates the applied printing material between the surface of the material bed and the carrier body.

According to a further exemplary embodiment, the method may further comprise moving the carrier body for forming a further layer of the cooling structure. After the printing of a layer of the cooling structure on/in the carrier body may be moved. In particular, the carrier body is lowered about the thickness of the next layer of the cooling structure which should be printed.

According to a further exemplary embodiment of the method, the three-dimensionally printing may comprise arranging the carrier body in a container. After the arranging of the carrier body the fluid material is consolidated by a treatment device, in particular a laser device, on and/or in the layer structures for forming at least one layer of the cooling structure. An ultraviolet laser may be used which is focused onto the container comprising the fluid material. The laser is used to consolidate/solidify desired regions of the fluid material for forming the defined design of the cooling structure. The fluid material may be consolidated, in particular solidified, more in particular cured, and forms a single layer of the desired cooling structure. These steps can be repeated for each layer of the cooling structure. An elevator platform may be used to move the carrier body or the surface onto which the cooling structure is to be printed. The elevator may be moved about a distance which is equal to a thickness of a single layer of the structure into the container. Next, a blade may sweep over the consolidated layer for providing a homogeneous distribution of the fluid material. Next, the laser consolidates, in particular solidifies, further desired regions of the fluid material for forming the defined design of the cooling structure. The steps are repeated until the desired 3-D structure, i.e. the cooling structure, is achieved. After forming of the complete cooling structure the component carrier maybe further cured in an ultraviolet oven. This process may also be used with mixed materials such as ceramic and photopolymer mixtures. During this process also more than one laser may be used.

According to a further exemplary embodiment, the fluid material is a photosensitive material, in particular the fluid material may be photosensitive under the ultraviolet light of the laser. A further process using fluidic materials may be the multi-jet modelling, poly jet method. In this process of fluidic light-sensitive plastic is applied onto a platform by a printhead and is immediately cured by a light source (e.g. a laser) integrated in the printhead.

It has to be noted that embodiments of the invention have been described with reference to different subject matters. In particular, some embodiments have been described with reference to apparatus type claims whereas other embodiments have been described with reference to method type claims. However, a person skilled in the art will gather from the above and the following description that, unless other notified, in addition to any combination of features belonging to one type of subject matter also any combination between features relating to different subject matters, in particular between features of the apparatus type claims and features of the method type claims is considered as to be disclosed with this document.

### Brief Description of the Drawings

The aspects defined above and further aspects of the present invention are apparent from the examples of embodiment to be described hereinafter and are explained with reference to the examples of embodiment. The invention will be described in more detail hereinafter with reference to examples of embodiment but to which the invention is not limited.
Fig. 1 shows a component carrier comprising a cooling structure having pins according to an exemplary embodiment of the invention.
Fig. 2 shows a component carrier comprising a cooling structure having pins according to a further exemplary embodiment of the invention.
Fig. 3 shows a cooling structure arranged within a component carrier according to an exemplary embodiment of the invention.
Fig. 4 shows a cooling structure formed as a fractal according to an exemplary embodiment of the invention.
Fig. 5 shows a cooling structure comprising a smooth surface.
Fig. 6 shows a cooling structure comprising a roughened surface according to an exemplary embodiment of the invention.
Fig. 7 shows a cooling structure comprising a high roughened surface according to an exemplary embodiment of the invention.
Fig. 8 shows a cooling structure formed as a tube according to an exemplary embodiment of the invention.
Fig. 9 shows a cooling structure formed as a torus according to an exemplary embodiment of the invention.
Fig. 10 shows a cooling structure comprising a ceramic body according to an exemplary embodiment of the invention.
Fig. 11 shows a cooling structure comprising a ceramic body according to a further exemplary embodiment of the invention
Fig. 12 shows a component carrier comprising a cooling structure according to an exemplary embodiment of the invention.
Fig. 13 shows a component carrier comprising a cooling structure formed as a lamella structure.
Fig. 14 shows a component carrier comprising a cooling structure with a rough surface.

### Detailed Description of Exemplary Embodiments

The illustrations in the drawings are schematic. It is noted that in different figures similar or identical elements are provided with the same reference signs.

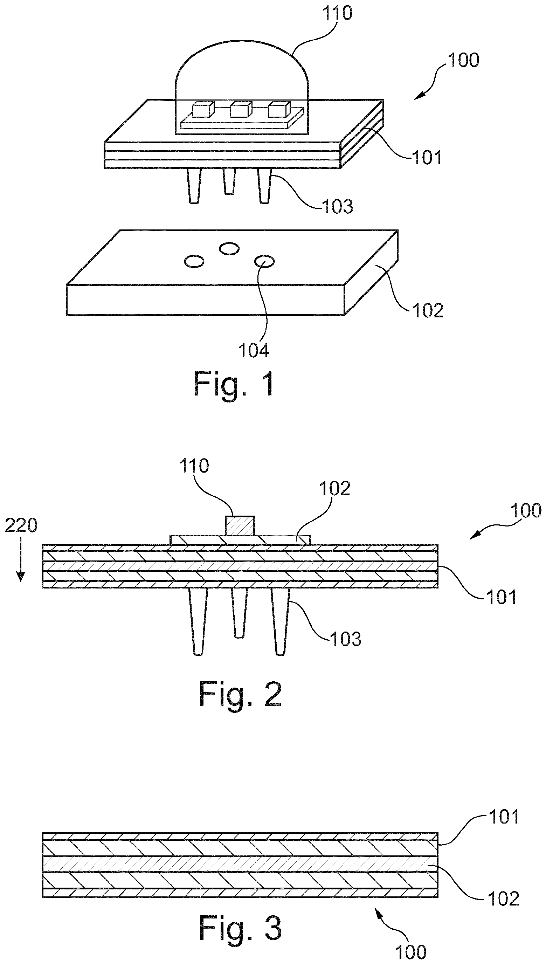

**Fig. 1** shows a component carrier 100 comprising a carrier body 101 and a cooling structure 102. The carrier body 101 may comprise a plurality of electrically conductive layer structures and/or electrically insulating layer structures. On the carrier body 101 a component 110 is mounted. The carrier body 101 comprises electrical and/or thermal connectors 103. In particular, the cooling structure 102 comprises connecting holes for the connectors 103 arranged at the carrier body 101. Both the cooling structure 102 and the connectors 103 may be functioning as cooling and/or electric system for the component carrier 100. Further the connectors 103 may be directly printed on electrical and/or thermal ends of the carrier body 101 such as copper planes and/or copper pillars. The component 110 may be for example one light emitting diode or an array of light emitting diodes or a transistor. The cooling structure 102 is directly attached on the carrier body 101, for instance when only the connectors 103 are 3D printed and the cooling structure is not formed by 3D printing. Further, the cooling structure 102 may be printed by three dimensionally printing and designed to fit the structures 103 on the carrier body 101 in a male female type connection.

**Fig. 2** shows a component carrier 100 comprising a plurality of electrically conductive layer structures and/or electrically insulating layer structures. Further, on the carrier body 101 a component 110 is arranged. The component is arranged directly on the cooling structure 102. Furthermore, connectors, in particular pins 103, are formed, wherein the pins 103 are formed extending from the cooling structure 102 by three dimensionally printing. The pins 103 are part from the cooling structure 102 and extend through the carrier body 101. Further, the cooling structure 102 is formed extending perpendicular with respect to the stacking direction 220 of the plurality of layer structures. Hence, the cooling structure 102 formed on the carrier body 101 extends perpendicular to the stacking direction 220. Hence, the pins 103 of the cooling structure extend along the stacking direction 220. Furthermore, as can be seen in Fig. 2 the cooling structure 102 comprises different cross sections, in particular along a stacking direction 220 of the plurality of layer structures of the carrier body 101. The pins 103 of the cooling structure 102 comprise different cross sections, in particular the pins 103 have tapering ends. It may also be possible that the cooling structure 102 arranged on top of the carrier body 101 comprises different cross sections perpendicular with respect to a stacking direction 220 of the plurality of layer structures.

**Fig. 3** shows a component carrier 100 comprising a cooling structure 102 formed with 3D printing within the carrier body 101. The cooling structure 102 may be designed for heat spreading purposes and is arranged between two top layer structures and two bottom layer structures of the carrier body 101. This cooling structure 102 is formed as an electrically insulated thermally conductive body, such as an insulating ceramic layer as well as of metallic materials. The cooling structure 102 may be electrically isolated from the surrounding. For example the thermally conductive body is an insulated thermally conductive metal body, i.e. an insulating metallic body (IMS). Furthermore, the cooling structure 102 may be a metallic body which is electrically conductive, such that the cooling structure may serve as a thermal conductor and simultaneously as an electrically conductor. The thermally conductive body is arranged within the carrier body 101 and comprises structures that may be design dependent on the dimensions of the carrier body 101. For instance in Fig. 3 the cooling structure comprises a design wherein the length and a width are adapted to be equal to the dimensions of the carrier body 101.

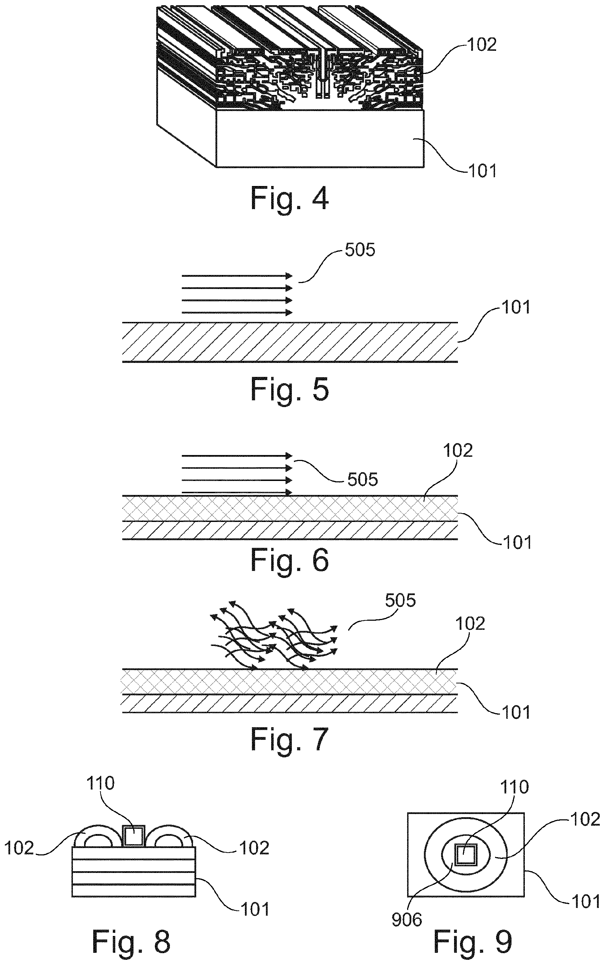

**Fig. 4** depicts a cooling structure 102 that is formed as a fractal. The fractal or also called as fractal structure is formed as a three dimensional structure. Fractal structures may be seen relatively easily in the nature. Trees are fractal formations that maximize the surface area for the determined volume in order to absorb maximum light. The heat sink in this case may have a tree format in order to maximize convection which is directly proportional to surface area. The fractal is directly formed on top of the carrier body 101 such that the fractal is a surface of the carrier body 101 being in contact to the ambient. The fractal cooling structure provides a large surface for heat dissipation, because the fractal cooling structure 102 has different openings between the respective branches of the fractal tree structure, wherein the opening increase the surface for heat dissipation. Other fractal structures may also be used.

**Fig. 5** shows a carrier body 101 having a smooth surface such that a laminar flow of a cooling medium 505 is generated.

**Fig. 6** shows a carrier body 101 comprising a cooling structure 102 having a roughened surface. In comparison to Fig. 5 the roughened surface allows to dissipate more heat than a smooth surface. The cooling medium 505 is also flowing with a laminar flow.

**Fig. 7** shows a carrier body 101 comprising a cooling structure 102 having a high roughened surface in comparison with the roughened surface shown in Fig. 6. This higher roughened surface generates a turbulent flow of the cooling medium 505 such that the heat exchange is improved.

**Fig. 8** shows a carrier body 101 comprising different layer structures. On the carrier body 101 a component 110 is arranged. Further, on the carrier body 101 a cooling structure 102 is arranged, wherein the cooling structure is formed as a tube. The tube formed cooling structure 102 is formed on both sides of the component 110 and extends along the carrier body 101. In particular the tube 102 extends perpendicular to a stacking direction 220 of the plurality of layer structures. The component 110 is arranged between the tubes of the cooling structure 102 such that heat generated by the component 110 can be dissipated by the adjacent tubes. It may also be possible that a plurality of components 110 may be arranged between the tubes of the cooling structure 102. The cooling structure 102 at least partially surrounds the component 110 such that at least two opposing surfaces are surrounded by the cooling structure 102 and at least two other opposing surfaces are free.

**Fig. 9** shows a carrier body 101 with a cooling structure formed as a torus structure. Inside the torus, i.e. at the center 906 of the torus a gap or hole is formed such that a component 110 may be arranged in the center 906 of the torus. The heat generated by the component 110 can be dissipated by the torus cooling structure 102 from all sides of the component 110.

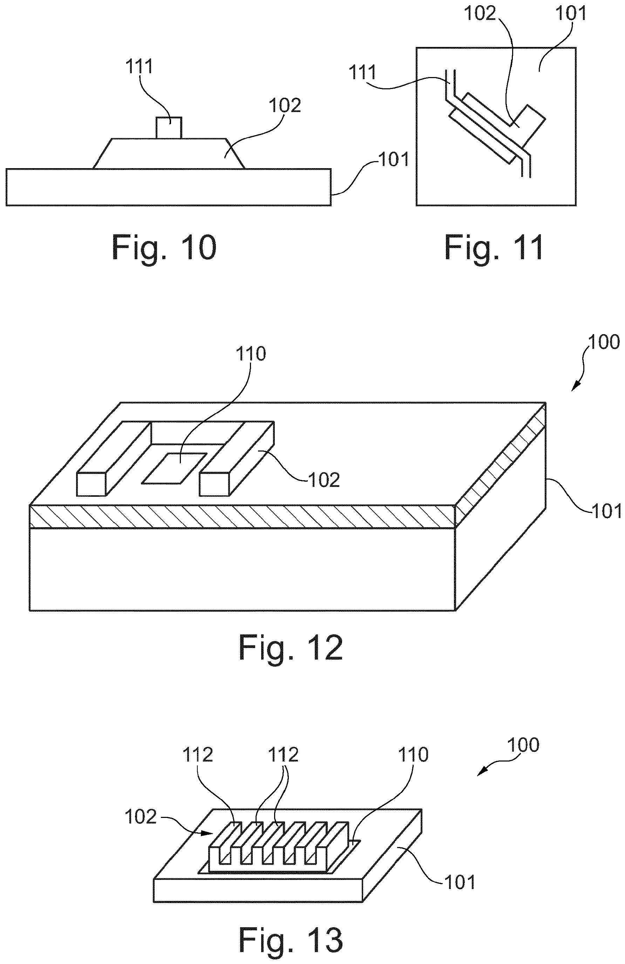

**Fig. 10** shows a carrier body 101, wherein on the carrier body 101 a cooling structure 102 is formed. The cooling structure 102 is formed as a thermically isolating ceramic body having a trapezoid shape. On top of the ceramic body (cooling structure 102) a heat generating element 111 is arranged. The heat generating element 111 may be a component or a conductive copper line.

**Fig. 11** shows the ceramic body described with Fig. 10. The heat generating element 111 is a copper line arranged on top of the ceramic body 102. The ceramic body 102 may have an extending part extending from the ceramic body into a direction perpendicular to the heat generating element 111 such that the heat is supported from dissipating away from the heat generating element. It may also be possible that a plurality of extending parts of the ceramic body 102 may be formed which extend away from the ceramic body 102 to a direction perpendicular of the extending direction of the ceramic body.

**Fig. 12** shows a carrier body 101 having a cooling structure 102 formed on the carrier body 101. The cooling structure 102 at least partially surrounds a component 110. In this embodiment, the cooling structure 102 surrounds the component 110 from three sides. The cooling structure 102 has a rectangular shape. Other shapes may also be possible such that the cooling structure may have a circular, oval or trapezoid shape.

**Fig. 13** shows a carrier body 101 having a cooling structure 102, wherein the cooling structure 102 is formed as a lamella structure 112. The cooling structure 102 is formed on top of a component 110. The cooling structure 102 comprises a plurality of lamella structure 112. The lamella structure 112 is increasing the surface for the heat dissipation of the cooling structure 102.

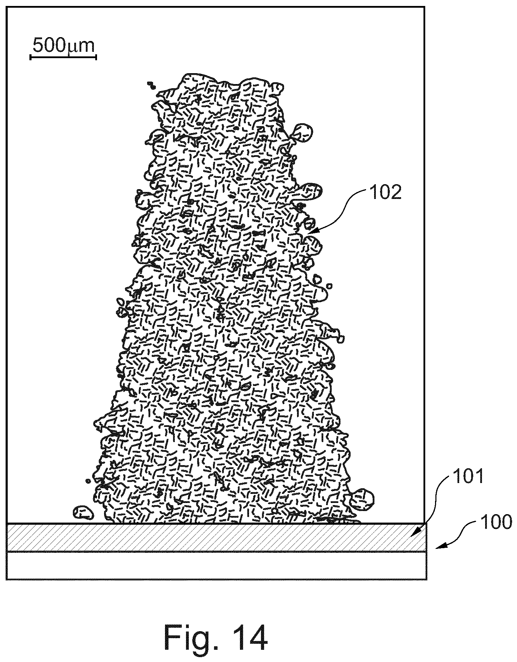

**Fig. 14** shows a component carrier 100 with a carrier body 101 wherein the carrier body 101 may be a copper layer. On the copper layer a cooling structure 102 is three dimensionally printed such that the cooling structure 102 comprises a rough surface. Fig. 14 shows an optical microscope image of a cross section of a cooling strucutre102 which is a copper structure realized by 3D printing directly on a copper foil (the carrier body 101). The copper foil is the surface of a typical FR4 Core material for a component carrier 100 which is a PCB (double side unstructured copper foil). As can be seen by the given scale the roughness can achieves almost 500 µm.

It should be noted that the term "comprising" does not exclude other elements or steps and "a" or "an" does not exclude a plurality. Also elements described in association with different embodiments may be combined. It should also be noted that reference signs in the claims should not be construed as limiting the scope of the claims.

### List of reference signs:

100 component carrier
101 carrier body
102 cooling structure
103 connector
104 connecting holes
110 component
111 heat generating element
112 lamella structure
220 stacking direction
505 cooling medium
906 center

## Claims

1. A component carrier, wherein the component carrier comprises:
a carrier body comprising a plurality of electrically conductive layer structures and/or electrically insulating layer structures; and
a cooling structure on and/or in the layer structures and being at least partially formed as a three-dimensionally printed structure.

2. The component carrier according to claim 1, further comprising
a component mounted on and/or embedded in the carrier body
wherein the cooling structure is in particular directly formed on the component.

3. The component carrier according to claim 1 or 2, wherein the cooling structure comprises a material selected of at least one of the group consisting of copper, aluminum, steel and ceramics.

4. The component carrier according to any of the claims 1 to 3,
wherein the cooling structure is formed at least partially within the carrier body,
wherein the cooling structure extends in particular along a stacking direction of the plurality of layer structures,
wherein the cooling structure is formed extending in particular perpendicular with respect to a stacking direction of the plurality of layer structures,
wherein the cooling structure comprises in particular different cross sections, in particular along a stacking direction of the plurality of layer structures and/or perpendicular with respect to a stacking direction of the plurality of layer structures.

5. The component carrier according to any of the claims 1 to 4,
wherein the cooling structure comprises at least one locally roughened surface which has a higher roughness than adjacent surfaces of the cooling structure for providing a heat exchange with a cooling medium,
wherein the cooling structure comprises in particular a heat pipe,
wherein the heat pipe comprises in particular a tube extending along the carrier body,
wherein the heat pipe forms in particular a tube which partially surrounds a heat generating component.

6. The component carrier according to any of the claims 1 to 5, comprising at least one of the following features:
wherein the cooling structure comprises a heat sink,
wherein the cooling structure is formed as a fractal structure,
wherein the cooling structure forms a lamella structure,
wherein the cooling structure forms a torus structure,
wherein the cooling structure is formed as an electrically insulated thermally conductive metal body,
wherein the cooling structure is configured as an electrical connector and/or thermal connector, and
wherein the cooling structure comprises pins and/or connecting holes, and
wherein the cooling structure comprises a thermal conductor, in particular a thermal conductive ceramic body, arranged on the carrier body,
wherein the thermal conductor comprises a cooling surface to which a heat generating element, such as a conductive line and/or an electronical component, is attachable.

7. The component carrier according to any of the claims 2 or 3, wherein the component is selected from a group consisting of an electronic component, an electrically non-conductive and/or electrically conductive inlay, a heat transfer unit, a light guiding element, an energy harvesting unit, an active electronic component, a passive electronic component, an electronic chip, a storage device, a filter, an integrated circuit, a signal processing component, a power management component, an optoelectronic interface element, a voltage converter, a cryptographic component, a transmitter and/or receiver, an electromechanical transducer, an actuator, a microelectromechanical system, a microprocessor, a capacitor, a resistor, an inductance, an accumulator, a switch, a camera, an antenna, a magnetic element, a further component carrier and a logic chip.

8. The component carrier according to any of claims 1 to 7, comprising at least one of the following features:
wherein the at least one electrically conductive layer structure comprises at least one of the group consisting of copper, aluminum, nickel, silver, gold, palladium, and tungsten, any of the mentioned materials being optionally coated with supra-conductive material such as graphene,
wherein the at least one electrically insulating layer structure comprises at least one of the group consisting of resin, in particular reinforced or non-reinforced resin, for instance epoxy resin or Bismaleimide-Triazine resin, FR-4, FR-5, cyanate ester, polyphenylene derivate, glass, prepreg material, polyimide, polyamide, liquid crystal polymer, epoxy-based Build-Up Film, polytetrafluoroethylene, a ceramic, and a metal oxide
wherein the component carrier is shaped as a plate,
wherein the component carrier is configured as one of the group consisting of a printed circuit board, and a substrate, and
wherein the component carrier is configured as a laminate-type component carrier.

9. A method of manufacturing a component carrier, wherein the method comprises:
providing a carrier body comprising a plurality of electrically conductive layer structures and/or electrically insulating layer structures;
forming a cooling structure on and/or in the layer structures at least partially by three-dimensionally printing.

10. The method according to claim 9, wherein the three-dimensionally printing comprises
applying a printing material to an application device,
melting the printing material in the application device,
applying the melted printing material on and/or in the carrier body for forming at least one layer of the cooling structure.

11. The method according to claim 9, wherein the three-dimensionally printing comprises
applying a printing material, in particular a powder material, on and/or in the carrier body,
consolidating the applied printing material for forming at least one layer of the cooling structure, wherein the cooling structure is in particular formed by at least one of the group consisting of selective laser melting, selective laser sintering, and electron beam, wherein in particular before consolidating the printing material the printing material is melted by a thermal treatment device, in particular a laser device.

12. The method according to claim 11,
wherein the printing material is applied a material delivery nozzle,
wherein the method in particular further comprising
moving the material delivery nozzle for forming a further layer of the cooling structure.

13. The method according to claim 12, wherein before the powder material is applied on and/ or in the carrier body the carrier body is moved into a material bed consisting of the printing material.

14. The method according to any of the claims 11 to 13, further comprising moving the carrier body for forming a further layer of the cooling structure.

15. The method according to claim 9,
wherein the method comprises arranging the carrier body in a container,
wherein the three-dimensionally printing comprises
providing a consolidateable fluid material in the container,
consolidating the fluid material by a treatment device, in particular a laser device, on and/or in the carrier body for forming at least one layer of the cooling structure,
wherein the fluid material is in particular a photosensitive material, wherein the method in particular further comprises
moving the carrier body for forming a further layer of the cooling structure.
